# EUROPEAN PATENT APPLICATION

(11) **EP 2 602 685 A1**
(43) Date of publication of application: **12.06.2013**
(21) Application number: 12189979.3
(22) Date of filing: 25.10.2012
(51) Int. Cl.: G05G 1/08, G01D 5/14

(54) **Multiple function control knob assembly**

(30) Priority: 04.11.2011 US 201113289352
(71) Applicant: Delphi Technologies, Inc., Troy, MI 48007 (US)
(72) Inventor: Padilla, Javier, El Paso, TX Texas 79932 (US)
(74) Representative: Allain, Michel Jean Camille

(57) **Abstract**

A multiple function control knob assembly (10) that includes a knob (12), a three dimensional Hall effect sensor (30), a magnet (32), and a processor (36). The knob (12) is configured to be movably rotated about an axis (14), and movably positioned along the axis (14). The three dimensional Hall effect sensor (30) is located proximate to the axis (14). The magnet (32) is fixedly coupled to the knob (12) so a magnet direction of the magnet (32) relative to the sensor (30) can be detected by the sensor (30). The processor (36) is configured to receive a signal from the sensor (30) indicative of the magnet direction, and determine an angular direction of the magnet (32) about the axis (14) and a linear position of the magnet (32) along the axis (14) based on the signal.

## Description

### TECHNICAL FIELD

This disclosure generally relates to a multiple function control knob assembly, and more particularly relates to an assembly equipped with a Hall effect type three dimensional position sensor and a knob configured to be movably rotated about an axis and movably positioned along the axis.

### BACKGROUND OF THE INVENTION

As the number and complexity of controllable features in an automobile increases, features such as entertainment systems, heating / ventilation / air conditioning (HVAC) systems, and navigation systems, the number of adjustable knobs, pushbutton switches, and information display devices also increases. In general, a control knob is rotated to select a function or adjust a level or characteristic of a function. For example, a control knob may adjust a volume level of an entertainment system, or adjust cabin temperature setting of an HVAC system. There is a desire for a single control knob to be able to control more than a single function. However, prior attempts at combining typical electromechanical devices such as variable resistor type potentiometers and push button assemblies has resulted in complicated, expensive, and unreliable multiple function control knob assemblies.

### SUMMARY OF THE INVENTION

In accordance with one embodiment, a multiple function control knob assembly is provided. The assembly includes a knob, a three dimensional Hall effect sensor, a magnet, and a processor. The knob is configured to be movably rotated about an axis and movably positioned along the axis. The three dimensional Hall effect sensor is located proximate to the axis. The magnet is fixedly coupled to the knob so a magnet direction of the magnet relative to the sensor can be detected by the sensor. The processor is configured to receive a signal from the sensor indicative of the magnet direction, and determine an angular direction of the magnet about the axis and a linear position of the magnet along the axis based on the signal.

The assembly further comprises a return spring configured to urge the knob toward a normal position along the axis and allow the knob to be moved to a pressed position along the axis. More particularly, the return spring may be a wave spring.

The assembly further comprises a detent spring configured to vary rotational torque of the knob such that the knob is urged to one of a plurality of detent positions.

The processor is further configured to determine when the knob is at a normal position along the axis and when the knob is at a pressed position along the axis. Also, the processor is further configured to provide a normal direction signal indicative of the angular direction of the magnet when the knob is at the normal position, and provide a pressed direction signal indicative of the angular direction of the magnet when the knob is at the pressed position.

The knob defines an opening about the axis.

The assembly further comprises a display device positioned within the opening, said display device configured to display information related to the magnet direction.

Further features and advantages will appear more clearly on a reading of the following detailed description of the preferred embodiment, which is given by way of non-limiting example only and with reference to the accompanying drawings.

### BRIEF DESCRIPTION OF THE DRAWINGS

The present invention will now be described, by way of example with reference to the accompanying drawings, in which:

Fig. 1 is a perspective view of a multiple function control knob assembly in accordance with one embodiment;

Fig. 2 is an exploded perspective view of the assembly of Fig. 1 in accordance with one embodiment;

Fig. 3 is sectional front view of the assembly of Fig. 1 in accordance with one embodiment; and

Fig. 4 is sectional side view of the assembly of Fig. 1 in accordance with one embodiment.

### DESCRIPTION OF THE PREFERRED EMBODIMENT

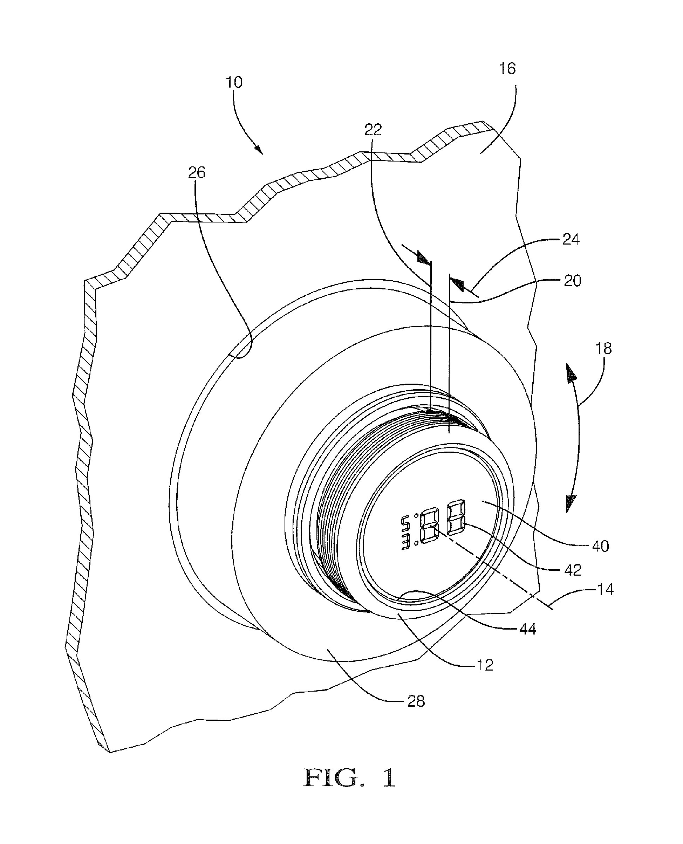

Fig. 1 is a perspective view of a non-limiting example of a multiple function control knob assembly 10. The assembly 10 includes a knob 12 configured to be movably rotated about an axis 14 that is generally oriented centrally through the knob 12. The rotary motion is generally suggested by an arced line 18. The assembly 10 may include a bezel 28 that is movably coupled to the knob 12 so the knob 12 can move relative to the bezel 28.

The assembly 10 is also configured so the knob 12 can be movably positioned linearly along the axis 14. The linear motion is generally suggested by a distance 24. Fig. 1 illustrates the knob 12 in a normal linear position 20, and suggests the knob 12 in a pressed linear position 22. As will be described in more detail below, the assembly 10 includes other features not show in Fig. 1 that cooperate to output a signal indicative of a rotary angle or rotary position of the knob 12 about the axis 14 corresponding to movement along the arced line 18, and indicative of a linear position of the knob 12 along the axis 14 corresponding to movement along the distance 24. As such, the assembly 10 provides a means to control multiple distinct functions without taking extra space on a vehicle instrument panel if a separate button or knob was provided for each function. In this non-limiting example, the assembly 10 is illustrated as protruding through a hole 26 in a cover plate 16 only for the purpose of providing a frame of reference for the illustration. The cover plate 16 may be part of a decorative or protective surface on a vehicle dash assembly or an instrument/device control panel.

The assembly 10 may also include a central portion or center 40 that is generally fixed relative to and positioned within an opening 44 defined by the knob 12. In general, the center 40 does not rotate if the knob 12 is rotated. As will become clear in the subsequent description, the center 40 may not move linearly with the knob 12. However, it is recognized that the assembly 10 could be configured so the center 40 does move linearly, but not rotationally as the knob 12 is moved. The center 40 may also include a display 42 that presents numbers or an image corresponding to linear and/or rotary motion of the knob 12. The display may be a simple numeric display as suggested by the illustration, or may be a reconfigurable pixel based display as is commonly found on many cellular phones.

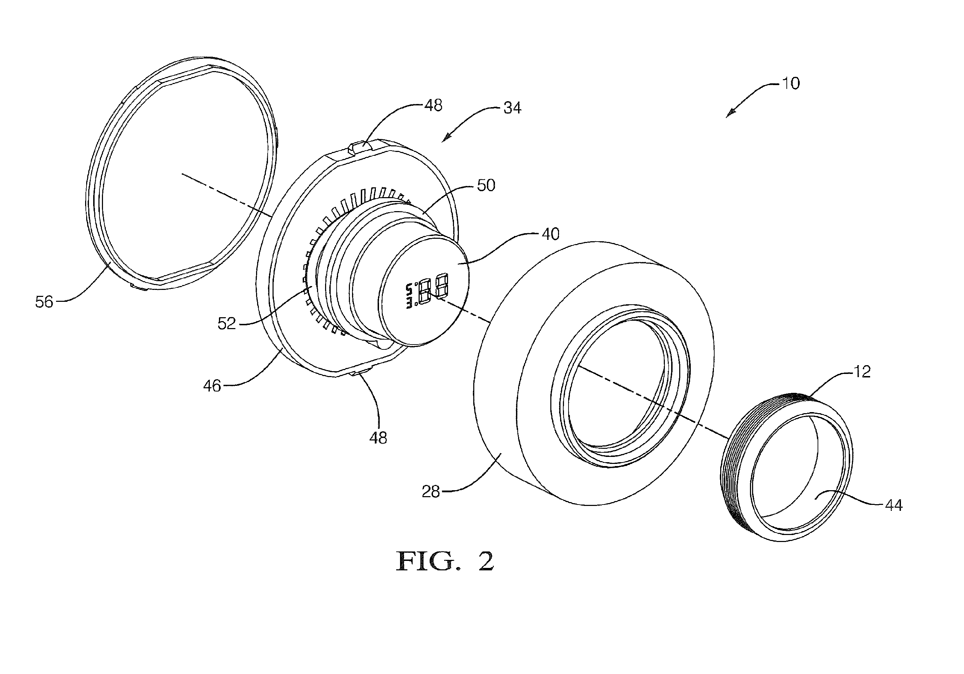

Fig. 2 is a non-limiting example of a perspective exploded view of the assembly 10 presented for the purpose of further illustrating the parts that make up the assembly 10. The assembly 10 may include a trim plate 46 that defines tab 48. The bezel 28 may define mating features (not shown) that cooperate with the tab 48 so that when the bezel 28 is pressed over the tab 48 it cannot be readily removed. The trim plate 46 may serve as a support structure for the center 40 and the display 42. The assembly 10 may include a return spring such as a wave spring 50 configured to urge the knob 12 into the normal position 20. By this arrangement, the wave spring 50 may provide an anti-rattle and anti-linear motion function as the various parts of the assembly 10 are sandwiched by the bezel 28 snap attaching to the trim plate 46. The wave spring 50 allows for the knob 12 to move as a person (not shown) presses on the outside perimeter of the knob 12.

The assembly 10 may include a detent spring 52 configured to vary rotational torque of the knob 12 such that the knob 12 is urged to one of a plurality of detent positions. The trip plate may include a plurality of indents 64 that cooperate with the indent spring 52 to provide a detent feel to the knob 12 as it is rotated.

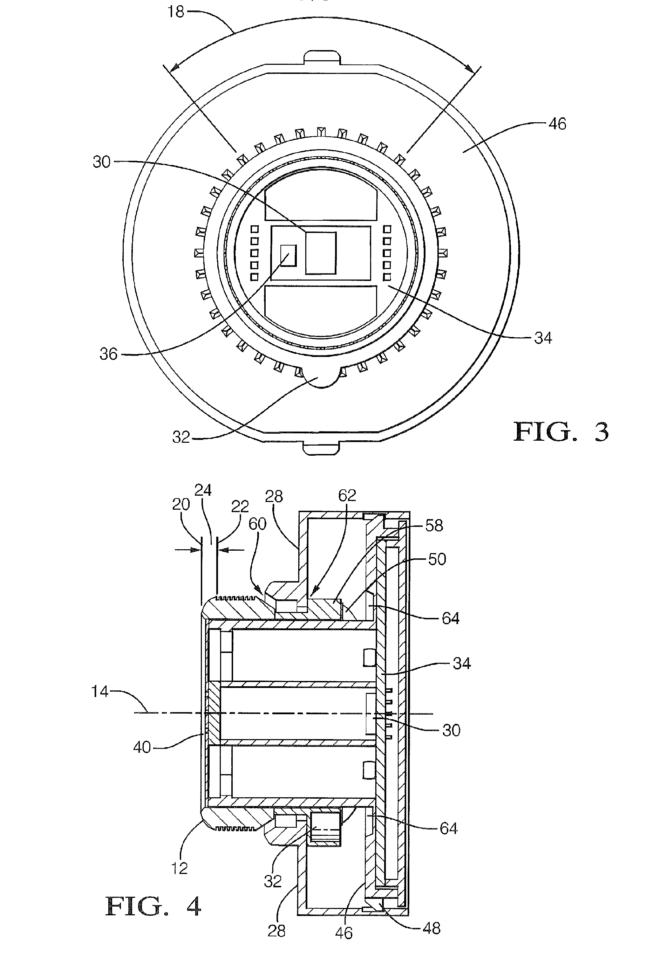

Continuing to refer to Fig. 2, a printed circuit board assembly 34 (PCB 34, Figs. 3 and 4) may be provided facilitate interconnection of electronics for detecting rotary and linear motion of the knob 12. A cover may be provided to protect the printed circuit board assembly 34 from dust, moisture, and physical impact damage. It is recognized that the assembly 10 may include a variety of seals such as O-rings at various locations for the purpose of further water/dust/contamination proofing the assembly 10.

Figs. 3 and 4 are cut-away front and side views, respectively, that further illustrate non-limiting details of a multiple function control knob assembly 10. The assembly 10 may include a three dimensional position sensor Hall effect sensor 30 preferably located proximate to the axis 14. A suitable example of the sensor is a MLX90333 manufactured by Melexis. It is contemplated that the sensor 30 may be located other than precisely centered on the axis 14. The sensor 30 may be soldered to the PCB 34 that may include wires or other suitable means known to those skilled in the art to electrically connect the PCB 34 to, for example, a vehicle electrical system (not shown). Alternatively, a lead frame assembly (not shown) may be used to electrically couple the sensor 30 to the vehicle electrical system to so electrical contact can be made with the sensor 30.

The sensor assembly may also include a magnet 32 fixedly coupled to the knob 12 so a magnet direction of the magnet 32 relative to the sensor 30 can be detected by the sensor 30. The magnet 32 is preferably a permanent magnet formed of neodymium magnet commonly known as a Neo type magnet. Such magnets are readily available from a wide variety of manufacturers. It is contemplated that other type of magnets may be used.

In this example, a retainer 58 is provided to couple the magnet 32 to the knob 12. The arrangement of the knob 12 and the retainer 58 provide a means for retaining the arrangement relative to the bezel 28. The knob 12 and the retainer may be fixedly attached by gluing, friction welding, or other processes known to those skilled in the art. When the knob 12 is urged to the normal position 20 by the wave spring 50, a gap 60 is present between the knob 12 and the bezel 28, and the retainer 58 is in contact with the bezel 28 at a stop location 62. If the knob is pressed toward the pressed position 22, i.e. pressed toward the PCB 34, the size of the gap 60 decreases while the retainer 58 and the bezel 28 are correspondingly spaced apart at the stop location 62.

In general, the sensor 30 outputs a signal that indicates the direction of the magnet 32 relative to the sensor 30 in Cartesian coordinates, that is X, Y, and Z-axis value coordinates. It should be appreciated that by using a three dimensional position sensor Hall effect sensor such as the Melexis MLX90333, the assembly 10 eliminates the typical potentiometer / variable resistor that mechanically moves a wiper making electrical contact with a strip of electrically resistive material combined with a separate switch that opens and closes contacts in a mechanical switch, and so eliminates the reliability problems associated with such devices. The packaging of the sensor 30 is in general moisture and contaminant resistant and so not readily influenced by contaminants that may be present in a vehicle. The overall environmental robustness of the assembly 10 is readily improved using known methods such as conformal coating of the sensor 30 and the PCB 34.

The assembly 10 may include a processor 36 configured to receive a signal from the sensor 30 indicative of the magnet direction in Cartesian coordinates. The processor 36 may be a microprocessor or other control circuitry as should be evident to those in the art. The processor 36 may include memory, including non-volatile memory, such as electrically erasable programmable read-only memory (EEPROM) for storing one or more routines, thresholds and captured data. The one or more routines may be executed by the processor to perform steps for determining if signals received by the processor 36 indicate rotary or linear motion of the knob 12 by detecting motion of the magnet 32 as described herein.

The processor 36 may also be configured to determine an angular direction of the magnet 32 about the axis 14 corresponding to an angle on the arced line 18, and determine a linear position of the magnet 32 along the axis 14 corresponding to a position along the distance 24 based on the signal. The processor 36 may be further configured to determine when the knob 12 is at a normal position along the axis and when the knob 12 is at a pressed position along the axis. The processor 36 may be further configured to provide a normal direction signal indicative of the angular direction of the magnet 32 when the knob 12 is at the normal position 20, and provide a pressed direction signal indicative of the angular direction of the magnet 32 when the knob 12 is at the pressed position.

Accordingly, a multiple function control knob assembly 10 is provided. The knob 12 may be rotated while in the normal position 20 to change a particular device setting, and rotated while in the pressed position 22 to change a different device setting. Alternatively, the knob may be repeatedly pressed in order to selectively 'page' through a list of devices settings that are adjustable.

While this invention has been described in terms of the preferred embodiments thereof, it is not intended to be so limited, but rather only to the extent set forth in the claims that follow.

## Claims

1. A multiple function control knob assembly (10) comprising:
a knob (12) configured to be movably rotated about an axis (14) and movably positioned along the axis (14);
a three dimensional hall effect sensor (30) located proximate to the axis (14);
a magnet (32) fixedly coupled to the knob (12) so a magnet direction of the magnet (32) relative to the sensor (30) can be detected by the sensor (30);
a processor (36) configured to receive a signal from the sensor (30) indicative of the magnet direction, and determine an angular direction of the magnet (32) about the axis (14) and a linear position of the magnet (32) along the axis (14) based on the signal;
a return spring configured to urge the knob (12) toward a normal position (20) along the axis (14) and allow the knob (12) to be moved to a pressed position (22) along the axis (14) and;
a detent spring (52) configured to vary rotational torque of the knob (12) such that the knob (12) is urged to one of a plurality of detent positions.

2. The assembly (10) in accordance with claim 1, wherein the return spring is a wave spring (50).

3. The assembly (10) in accordance with any of the preceding claims, wherein the processor (36) is further configured to determine when the knob (12) is at a normal position (20) along the axis (14) and when the knob (12) is at a pressed position (22) along the axis (14).

4. The assembly (10) in accordance with claim 3, wherein the processor (36) is further configured to provide a normal direction signal indicative of the angular direction of the magnet (32) when the knob (12) is at the normal position (20), and provide a pressed direction signal indicative of the angular direction of the magnet (32) when the knob (12) is at the pressed position (22).

5. The assembly (10) in accordance with any of the preceding claims, wherein the knob (12) defines an opening (44) about the axis (14).

6. The assembly (10) in accordance with claim 5, wherein the assembly (10) further comprises a display (42) device positioned within the opening (44), said display (42) device configured to display (42) information related to the magnet direction.
